# EUROPEAN PATENT APPLICATION

(11) **EP 1 840 972 A2**
(43) Date of publication of application: **03.10.2007**
(21) Application number: 07251417.7
(22) Date of filing: 30.03.2007
(51) Int. Cl.: H01L 27/32

(54) **Organic light-emitting display device**

(30) Priority: 30.03.2006 KR 20060029235
(71) Applicant: Samsung SDI Co., Ltd., Suwon-si, Gyeonggi-do (KR)
(72) Inventor: Choi, Dae-chul, Legal & IP Team, Yongin-si Gyeonggi-do (KR); Choi, Byoung-deog, Legal & IP Team, Yongin-si Gyeonggi-do (KR); Kim, Kyoung-bo, Legal & IP Team, Yongin-si Gyeonggi-do (KR)
(74) Representative: Mounteney, Simon James

(57) **Abstract**

An organic light emitting display device (20), which has a photo diode (240) for receiving light of blue wavelengths. In one embodiment, an organic light emitting display device includes: a substrate (200) having pixel (A) and non-pixel regions (8); first (210) and second buffer layers (220) disposed over the substrate; a thin film transistor (TFT) (230) disposed over the second buffer layer; an organic light emitting diode (260) disposed in the pixel region over the TFT and electrically connected with the TFT; and a photo diode (240) disposed on the second buffer layer in the non-pixel region and adapted to receive incident light of blue wavelength from an external source. A thickness of the first buffer layer (210) ranges from 700 to 900 Å, and a thickness of the second buffer layer (220) ranges from 500 to 700 Å. The photo diode (240) includes N-type (241) and P-type doping regions (243) and an intrinsic region (242) having a width ranging from 1 to 10 μm.

## Description

### BACKGROUND

### 1. Field of the Invention

The present invention relates to an organic light emitting display device, which has a photo diode for receiving light of blue wavelengths incident from an external source to a non-pixel region.

### 2. Discussion of Related Art

In general, an organic light emitting display device includes a pair of electrodes having an anode electrode and a cathode electrode, and a light emitting layer. It may further include a hole injecting layer, a hole transporting layer, an electron injecting layer and an electron transporting layer. Such an organic light emitting display device emits light according to the following light emitting principle. Holes are injected into the hole injecting layer from the anode electrode, and the injected holes are transported to the light emitting layer through the hole transporting layer. Further, electrons are injected into the electron injecting layer from the cathode electrode, and the injected electrons are transported to the light emitting layer through the electron transporting layer.
The transported holes and the transported electrons are coupled with each other in the light emitting layer to form excitons. When the excitons fall to a lower energy level, the light emitting layer emits light.

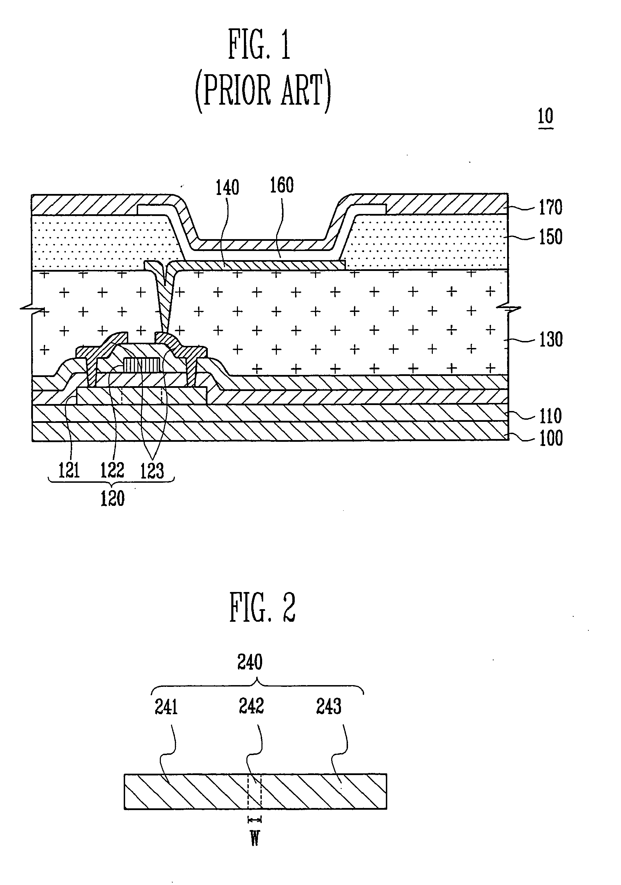

Hereinafter, a conventional organic light emitting display device will be described in more detail with reference to FIG. 1.

FIG. 1 is a cross-sectional view of a conventional organic light emitting display device.

Referring to FIG. 1, the organic light emitting display device 10 includes a buffer layer 110 formed on a substrate 100 and a thin film transistor (TFT) 120 disposed on the buffer layer 110. The TFT 120 includes a semiconductor layer 121, a gate electrode 122, and source and drain electrodes 123. A planarization layer 130 is disposed on the TFT 120. A first electrode layer 140 is disposed on the planarization layer 130 and is electrically connected with the source or drain electrode 123. A pixel definition layer 150 is disposed on the first electrode layer 140 and the planarization layer 130. The pixel definition layer 150 includes an opening at least partially exposing the first electrode layer 140. A light emitting layer 160 is disposed on the first electrode layer 140 in the opening of the pixel definition layer 150. The organic light emitting display device 10 may further include a hole injecting layer, a hole transporting layer, an electron transporting layer and/or an electron injecting layer. A second electrode layer 170 is disposed over the light emitting layer 160.

Organic materials forming the light emitting layer 160 of the organic light emitting display device 10 may be deteriorated, causing a change in brightness of a pixel as time passes, resulting in that image quality or brightness of a display has values different from expected values. Accordingly, the organic light emitting display device may not have a long lifespan.

In order to solve the above problems, an approach of forming a photo diode in the organic light emitting display device has been proposed. This approach allows for a uniform brightness to be represented for an input signal regardless of a deterioration of the organic light emitting display device by using the photo diode to convert light energy received by (or incident on) the photo diode into an electric signal.

However, the aforesaid photo diode has a relatively low light receiving rate of less than 50% according to a wavelength of light. Therefore, there is a limit to a degree to which the brightness of the organic light emitting display device can be controlled using a photo diode.

### SUMMARY OF THE INVENTION

An aspect of the present invention provides an organic light emitting display device having a photo diode for receiving light of blue wavelengths incident from an external source to a non-pixel region. A quantum efficiency of the photo diode can be increased by controlling a thickness of a buffer layer below the photo diode and a width of an intrinsic region of the photo diode.

According to an aspect of the present invention, there is provided an organic light emitting display device as set out in Claim 1. Preferred features of this aspect are set out in claims 2 to 15.

### BRIEF DESCRIPTION OF THE DRAWINGS

These and/or other aspects and features of the invention will become apparent and more readily appreciated from the following description of exemplary embodiments, taken in conjunction with the accompanying drawings of which:

FIG. 1 is a cross-sectional view of a conventional organic light emitting display device;

FIG. 2 is a cross-sectional view of a photo diode according to an embodiment of the present invention;

FIG. 3 is a cross-sectional view of an organic light emitting display device having a photo diode according to an embodiment of the present invention; and

FIG. 4 is a graph showing a quantum efficiency of a photo diode receiving light of blue wavelengths from an external source according to an embodiment of the present invention.

### DETAILED DESCRIPTION

Exemplary embodiments of the present invention will be described in a more detailed manner with reference to the accompanying drawings.

FIG. 2 is a cross-sectional view of a photo diode according to an embodiment of the present invention.

Referring to FIG. 2, the photo diode 240 includes an N-type doping region 241, a P-type doping region 243 separated from the N-type doping region 241 at a distance of from 1 µm to 10 µm, and an intrinsic region 242 disposed between the N-type doping region 241 and the P-type doping region 243. The N-type and P-type doping regions 241 and 243 and the intrinsic region 242 may all be formed on a single plane.

The photo diode 240 may be composed of a polycrystalline silicon which can be obtained by crystallizing amorphous silicon with a heat treatment (which may be a predetermined heat treatment). The N-type doping region 241 may be formed by injecting a high concentration of ions of N-type impurities into a first region of the polycrystalline silicon. In substantially the same manner, the P-type doping region 243 may be formed by injecting a high concentration of ions of P-type impurities into a second region thereof.

The intrinsic region 242 is formed between the N-type doping region 241 and the P-type doping region 243, as an intrinsic layer that is a region of the polycrystalline silicon into which the N-type impurities and the P-type impurities are not injected. The intrinsic region 242 generates charges according to light incident on its surface and converts the charges into electric energy. In one embodiment, the intrinsic region 242 is formed to be from 1 µm to 10 µm in width W. By forming the intrinsic region 242 to be from 1 µm to 10 µm in width W, a quantum efficiency of the photo diode 240 over a blue-wavelength range can be from 50% to 95%. In one embodiment, the intrinsic region 242 is formed to be 1 µm in width W, since an aperture ratio (or opening ratio) of a pixel can be improved by reducing a size of a junction area between the N-type doping region 241 and the P-type doping region 243 and the quantum efficiency over the blue-wavelength range is more than 50% at this width. When the intrinsic region 242 is formed to be less than 1 µm in width W, the quantum efficiency over the blue-wavelength range may be less than 50% such that the brightness of an organic light emitting display device using the photo diode 240 may not be properly controlled. Also, when the intrinsic region 242 is formed to be wider than 10 µm in width W, an area occupied by the photo diode 240 may become large enough such that the aperture ratio may be deteriorated.

In operation, an anode voltage ANODE is applied to the N-type doping region 241, and a cathode voltage CATHODE is applied to the P-type doping region 243. The intrinsic region 242 becomes fully depleted (i.e., it enters a full depletion state). Accordingly, the intrinsic region generates and accumulates charges by absorbing externally applied light energy of blue wavelengths, i.e., wavelengths ranging from 450 nm to 480 nm, and converts them into electrical signals.

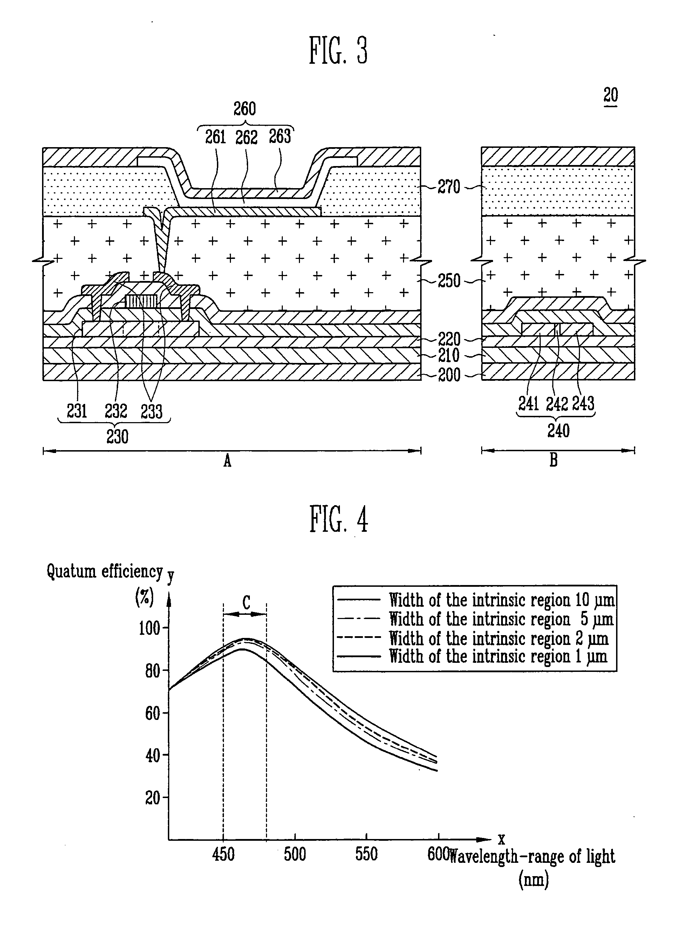

FIG. 3 is a cross-sectional view of an organic light emitting display device having a photo diode according to one embodiment of the present invention.

Referring to FIG. 3, an organic light emitting display device 20 includes: a substrate 200 having a pixel region A and a non-pixel region B; a first buffer layer 210 and a second buffer layer 220 formed on the substrate 200; a thin film transistor (TFT) 230 formed on the second buffer layer 220; an organic light emitting diode 260 formed on the TFT 230 and electrically connected with the TFT 230; and a photo diode 240 formed on the second buffer layer 220 in the non-pixel region B and for receiving incident light of blue wavelengths from an external source, wherein a thickness of the first buffer layer 210 is about 700 Å (0.07 µm) to 900 Å (0.09 µm) and a thickness of the second buffer layer 220 is about 500 Å (0.05 µm) to 700 Å (0.07 µm), and wherein the photo diode 240 includes an N-type doping region 241, an intrinsic region 242 having a width in a range from about 1 µm to 10 µm, and a P-type doping region 243.

The substrate 200 may be made of an insulated material such as glass, plastic, silicon or synthetic resin. In some embodiments, the substrate 200 is a transparent substrate such as a glass substrate. In some embodiments, the pixel region A refers to a region substantially for displaying an image, and the non-pixel region B refers to all regions other than the pixel region A of the substrate 200.

The first buffer layer 210 is formed on the substrate 200. The first buffer layer 210 may be made of a silicon oxide film SiO₂. In one embodiment, the thickness of the first buffer layer 210 is in a range from about 700 Å (0.07 µm) to 900 Å (0.09 µm). In one embodiment, the thickness of the first buffer layer 210 is about 800 Å (0.08 µm). The second buffer layer 220 may be made of a silicon nitride film SiNx. In one embodiment, the thickness of the second buffer layer 220 is in a range from about 500 Å (0.05 µm) to 700 Å (0.07 µm).
In one embodiment, the thickness of the second buffer layer 220 is about 600 Å (0.06 µm). The first buffer layer 210 and the second buffer layer 220 are formed to have the above-specified thicknesses because these thicknesses allow the photo diode 240 to receive the incident light of blue wavelengths. A first buffer layer 210 having a thickness less than 700 Å (0.07 µm) and a second buffer layer 220 having a thickness less than 500 Å (0.05 µm) may not be effective in preventing the diffusion of impurities into the TFT 230 and, subsequently, the photo diode 240. In contrast, a first buffer layer 210 of more than 900 Å (0.09 µm) in thickness and a second buffer layer 220 of more than 700 Å (0.07 µm) in thickness may not be beneficial in view of the recent trend of developing ultra-lightweight and ultra-thin display devices. The first buffer layer 210 and the second buffer layer 220 according to the above-described embodiments of the present invention are more effective in preventing the diffusion of impurities while the TFT 230 and the photo diode 240 are being formed to be post-processed.

The TFT 230 is formed on the second buffer layer 220 in the pixel region A. The TFT 230 has a semiconductor layer 231, a gate electrode 232, and source and drain electrodes 233. The TFT 230 can be formed using a low temperature polysilicon (LTPS) obtained by crystallizing an amorphous silicon layer formed on the second buffer layer 220 by using an irradiating laser or the like. A gate insulating layer may be disposed on the semiconductor layer 231. The gate electrode 232 may be disposed on the gate insulating layer in a certain pattern (which may be predetermined). An inter-layer insulating layer may be disposed on the gate electrode 232.

The source and drain electrodes 233 of the TFT 230 may be disposed on or over the inter-layer insulating layer and electrically connected with both sides of the semiconductor layer 231, respectively, through contact holes formed through the gate insulating layer and the inter-layer insulating layer.

The photo diode 240 may be formed on the second buffer layer 220 in the non-pixel region B. The photo diode 240, which has a P-i (intrinsic)-N structure, includes: an N-type doping region 241 to which a positive voltage is applied; a P-type doping region 243 to which a negative voltage is applied; and an intrinsic region 242 formed to be from about 1 µm to 10 µm in width.

In general, a photo diode, which is an optical sensor for obtaining an electrical signal (current or voltage) from a light signal by converting light energy into electric energy, is a semiconductor device formed with a light detecting function at a junction part of the diode. Here, this photo diode uses a principle that a conductivity of a diode is modulated depending on a light signal, since electrons or holes are generated by the absorption of photons. That is, the current of the photo diode is intrinsically changed according to an optical generation rate of charge carriers, and this property converts a light signal as time passes into an electrical signal.

The photo diode 240 can be obtained through the following process. First, an amorphous silicon layer is deposited in the non-pixel region B, and the amorphous silicon layer is crystallized to form polycrystalline silicon with a heat treatment (which may be a predetermined heat treatment). Thereafter, the N-type doping region 241 is formed by injecting a high concentration of ions of N-type impurities into a first region of the polycrystalline silicon. In substantially the same manner, the P-type doping region 243 is formed by injecting a high concentration of ions of P-type impurities into a second region thereof, which is horizontally separated from the first region.

Also, the intrinsic region 242 is disposed between the N-type doping region 241 and the P-type doping region 243, as an intrinsic layer that is a region of the polycrystalline silicon not doped by the N-type impurities and the P-type impurities. The intrinsic region 242 generates charges according to light incident on a surface of the intrinsic region 242 and converts them into electric energy. In one embodiment, the intrinsic region 242 is formed to be from 1 µm to 10 µm in width. The intrinsic region 242 ranging from about 1 µm to 10 µm in width has a quantum efficiency between about 50% and 95% over a blue-wavelength range. In one embodiment, the width of the intrinsic region 242 is from about 2 µm to about 10 µm.

In operation, an anode voltage ANODE is applied to the N-type doping region 241, and a cathode voltage CATHODE is applied to the P-type doping region 243. Accordingly, the intrinsic region 242 becomes fully depleted, and generates and accumulates charges by absorbing light energy of the incident light over the blue-wavelength range, that is, wavelengths ranging from 450 nm to 480 nm, to output electrical signals.

The photo sensor 240 may absorb light emitted from the organic light-emitting diode 260 and convert it into electrical signals. In particular, light absorbed by the photo sensor 240, i.e., actual luminance values of the organic light-emitting diode 260, may be compared to a predetermined luminance reference value. Any deviation of the actual luminance values from the predetermined luminance reference value may be controlled by the photo sensor 240 via electrical signals, thereby facilitating constant luminance output from the organic light-emitting diode 260, i.e., light generated by the light emitting layer 262. For example, electric signals generated by the photo sensor 240 may be inputted into a comparator for comparing actual luminance values with the predetermined luminance reference value.

More specifically, when the electric signal outputted from the photo sensor 240, i.e., signals representing actual luminance values, is lower than the predetermined luminance reference value, the comparator may generate a control signal to increase the luminance of light emitted by the light-emitting layer 262 of the organic light-emitting diode 260. Similarly, when the electric signal outputted from the photo sensor 240 is higher than the predetermined luminance reference value, the comparator may generate a control signal to reduce the luminance of light emitted by the light-emitting layer 262 of the organic light-emitting diode 260.

Alternatively, electric signals, i.e., electric current or a voltage, generated by the photo sensor 240 with respect to an amount of light absorbed from the organic light-emitting diode 260 may be supplied to a controller, so that the controller may output a respective control signal for controlling the luminance of the light-emitting layer 262 with respect to the light emitted therefrom. Accordingly, the photo sensor 240 may maintain constant luminance of light generated in the light-emitting layer 262 of the organic light-emitting diode 260.

The planarization layer 250 is formed over the TFT 230 and is made of a silicon oxide film SiO₂ or a silicon nitride film SiNx.

The organic light emitting diode 260 is formed over the planarization layer 250, and the organic light emitting diode 260 is electrically connected with the TFT 230. The organic light emitting diode 260 includes a first electrode layer 261, a light emitting layer 262, and a second electrode layer 263.

The light emitting layer 262 and the second electrode layer 263 of the organic light emitting diode 260 are formed over the first electrode layer 261. The organic light emitting diode 260 is formed over the planarization layer 250, and is electrically connected with the source or the drain electrodes 233 through a via hole formed such that the source or the drain electrodes 233 is exposed by etching an area of the planarization layer 250.

A pixel definition layer (or pixel definition film) 270, which is formed over the planarization layer 250, includes an opening at least partially exposing the first electrode layer 261. The pixel definition layer 270 is made of one or more suitable organic insulation materials such as acrylic organic compounds, polyamides, polyimides, etc. However, embodiments of the present invention are not limited to such a pixel definition layer 270.

The light emitting layer 262 of the organic light emitting diode 260 is formed in the opening of the pixel definition layer 270 partially exposing the first electrode layer 261. The organic light emitting diode 260 can further include, at least in part, a hole injecting layer, a hole transporting layer, an electron transporting layer and an electron injecting layer. Here, the light emitting layer 262 can generate light as a result of the injected holes and the injected electrons from the first and second electrode layers 261 and 263, respectively, being combined with each other.

The second electrode layer 263 of the organic light emitting diode 260 is formed on the light emitting layer 262 and the pixel definition layer 270. Also, in embodiments of the present invention, used in an organic light emitting display device that has a bottom emission type structure, at least one layer of the second electrode layer 263 is made of a reflective metal film.

FIG. 4 is a graph showing a quantum efficiency of a photo diode receiving externally applied light of blue wavelengths according to an embodiment of the present invention.

Referring to FIG. 4, the X-axis of the graph represents a wavelength range, and the Y-axis represents a quantum efficiency of a photo diode. In more detail, the graph shows the quantum efficiency of the photo diode for receiving externally applied light of blue wavelengths is dependent on a width of an intrinsic region of the photo diode, wherein a first buffer layer is 800 Å (0.08 µm) in thickness and a second buffer layer is 600 Å (0.06 µm) in thickness, the first buffer layer and the second buffer layer being formed below the photo diode.

For example, when an intrinsic region is 1 µm in width in a blue wavelength band C, that is, in a wavelength band ranging from 450 nm to 480 nm, the quantum efficiency is approximately 85%. Also, when the intrinsic region is formed to be from 2 µm to 10 µm in width, the quantum efficiency is in a range from 85% to 95%.

Accordingly, when the intrinsic region is formed to be from 1 µm to 10 µm in width W, the quantum efficiency is in a range from 85% to 95%.
When the intrinsic region is less than 1 µm in width, the quantum efficiency may be in a range from 20% to 40% and sufficient charges may not be generated such that the brightness of the organic light emitting device using the photo diode may not be properly controlled.

As described above, embodiments of the present invention provide an organic light emitting display device having a photo diode for receiving light of blue wavelengths incident on a non-pixel region. According to the embodiments of the present invention, the quantum efficiency of the photo diode can be increased to be from 50% to 95% by controlling a thickness of one or more buffer layers formed below the photo diode and a width of the intrinsic region of the photo diode. A brightness of the organic light emitting display device can be controlled to be substantially uniform by using electrical signals output from the photo diode. Therefore, a change in the brightness due to deterioration of the organic light emitting device can be minimized or reduced, thereby extending a useful lifespan of the device.

Furthermore, a high quality image in accordance with a high definition of a display can be provided by controlling a desired current to be flowed into an organic light emitting device provided in each pixel.

Although a few embodiments of the present invention have been shown and described, it would be appreciated by those skilled in the art that changes may be made in these embodiments without departing from the principles of the invention, the scope of which is defined in the claims and their equivalents.

## Claims

1. An organic light emitting display device comprising:
a substrate having a pixel region and a non-pixel region;
a first buffer layer and a second buffer layer disposed over the substrate;
a thin film transistor disposed over the second buffer layer;
an organic light emitting diode disposed in the pixel region over the thin film transistor and electrically connected with the thin film transistor; and
a photo diode disposed on the second buffer layer in the non-pixel region and adapted to receive incident light of blue wavelength from an external source,
wherein a thickness of the first buffer layer ranges from about 0.07 µm to about 0.09 µm and a thickness of the second buffer layer ranges from about 0.05 µm to about 0.07 µm, and
wherein the photo diode comprises an N-type doping region, an intrinsic region having a width ranging from about 1 µm to about 10 µm, and a P-type doping region.

2. An organic light emitting display device according to claim 1, wherein the photo diode is formed on the second buffer layer in the non-pixel region, and wherein the photo diode is separated from the thin film transistor.

3. An organic light emitting display device according to claim 1 or 2, wherein the first buffer layer is made of silicon oxide.

4. An organic light emitting display device according to any one of claims 1 to 3, wherein the second buffer layer is made of silicon nitride.

5. An organic light emitting display device according to any one of claims 1 to 4, wherein:
the N-type doping region is formed on the second buffer layer in the non-pixel region,
the P-type doping region is formed on the second buffer layer in the non-pixel region and is separated from the N-type doping region at a distance ranging from about 1 µm to about 10 µm,
the intrinsic region is formed between the N-type doping region and the P-type doping region, and
the N-type doping region, the P-type doping region, and the intrinsic region are all formed on a single plane.

6. An organic light emitting display device according to any one of claims 1 to 5, wherein the photo diode is adapted to output an electrical signal corresponding to the incident light of blue wavelength.

7. An organic light emitting display device according to claim 6, wherein the organic light emitting display device is adapted to use the electrical signal to control a brightness of light emitted from the organic light emitting diode.

8. An organic light emitting display device according to any one of claims 1 to 7, wherein the blue wavelength comprises a wavelength band that ranges from about 450 nm to about 480 nm.

9. An organic light emitting display device according to any one of claims 1 to 8, wherein the photo diode is formed from an amorphous silicon layer.

10. An organic light emitting display device according to any one of claims 1 to 9, wherein the organic light emitting display device has a bottom emission type structure.

11. An organic light emitting display device according to any one of claims 1 to 10, wherein the width of the intrinsic region is in a range from about 2 µm to about 10 µm.

12. An organic light emitting display device according to any one of claims 1 to 11, wherein the substrate includes glass, plastic, silicon, or synthetic resin.

13. An organic light emitting display device according to claim 12, wherein the substrate is a glass substrate.

14. An organic light emitting display device according to any one of claims 1 to 13, wherein the thickness of the first buffer layer is about 0.08 µm.

15. An organic light emitting display device according to any one of claims 1 to 14, wherein the thickness of the second buffer layer is about 0.06 µm.

16. An organic light emitting display device according to any one of claims 1 to 15, further comprising:
a planarization layer disposed on the thin film transistor;
wherein the an organic light emitting diode is disposed on the planarization layer in the pixel region.
